(19) Europäisches Patentamt
European Patent Office
Office européen des brevets

(11) **EP 2 816 680 A1**

(12) **EUROPÄISCHE PATENTANMELDUNG**

(43) Veröffentlichungstag:
**24.12.2014 Patentblatt 2014/52**

(51) Int Cl.:
*H01S 5/10* (2006.01)      *H01S 5/40* (2006.01)

(21) Anmeldenummer: **13172422.1**

(22) Anmeldetag: **18.06.2013**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(71) Anmelder: **PBC Lasers GmbH**
**10623 Berlin (DE)**

(72) Erfinder: **Kettler, Thorsten**
**10247 Berlin (DE)**

(74) Vertreter: **Fischer, Uwe**
**Patentanwalt**
**Moritzstraße 22**
**13597 Berlin (DE)**

(54) **Laser**

(57)     Die Erfindung bezieht sich auf einen Laser (1) mit einem Laserchip (10), der eine Mehrzahl aktiver Laserkanäle (20), eine Frontfacette (10a) zur Auskopplung der Laserstrahlung der Laserkanäle (20) und eine Rückfacette (10b) zur rückseitigen Reflexion der Laserstrahlung der Laserkanäle (20) in Richtung Frontfacette (10a) aufweist.

Erfindungsgemäß ist vorgesehen, dass zumindest einer der Laserkanäle (20) zumindest abschnittsweise gekrümmt ist.

Fig. 17

**Beschreibung**

Die Erfindung bezieht sich auf einen Laser mit einem Laserchip, der eine Mehrzahl aktiver Laserkanäle, eine Frontfacette zur Auskopplung der Laserstrahlung der Laserkanäle und eine Rückfacette zur rückseitigen Reflexion der Laserstrahlung der Laserkanäle in Richtung Frontfacette aufweist.

Halbleiterlaser mit sehr hoher optischer Ausgangsleistung werden häufig für die Materialbearbeitung eingesetzt. Um eine hohe optische Leistung im Bereich von einigen 10W bis hin zu kW zu erreichen, werden bekanntermaßen z. B. Breitstreifenlaser eingesetzt. Diese vorbekannten Laser emittieren eine breite, vielmodige Strahlkeule. Diese Strahlkeule hat eine vergleichsweise schlechte Strahlqualität, wodurch die optische Energie des Laserchips nur schlecht fokussiert werden kann. Dadurch ist bei diesen Laserchips die erreichbare Leistungsdichte in einem Fokuspunkt begrenzt.

Weiterhin ist bekannt, Laserchips zu verwenden, die viele einzelne aktive Laserkanäle auf einem Chip aufweisen. Wenn diese Laserkanäle sehr dicht nebeneinander angeordnet sind, kann die Strahlung der benachbarten Kanäle miteinander optisch durch Interferenz koppeln und es können sich wenige, spezielle optische Moden ausbilden, die zu einer Einengung der emittierten Strahlkeule führen können. Dieses ist vorteilhaft, da man die optische Energie auf einem kleineren Raum gut konzentrieren kann.

Der Erfindung liegt die Aufgabe zugrunde, einen Laser mit einer Mehrzahl aktiver Laserkanäle anzugeben, der bessere Emissionseigenschaften als vorbekannte Laser dieser Bauart aufweist.

Diese Aufgabe wird erfindungsgemäß durch einen Laser mit den Merkmalen gemäß Patentanspruch 1 gelöst. Vorteilhafte Ausgestaltungen des erfindungsgemäßen Lasers sind in Unteransprüchen angegeben.

Danach ist erfindungsgemäß vorgesehen, dass zumindest einer der Laserkanäle zumindest abschnittweise gekrümmt ist.

Ein wesentlicher Vorteil des erfindungsgemäßen Lasers ist darin zu sehen, dass durch das Vorsehen abschnittsweise gekrümmter Laserkanäle das Auskoppelverhalten an der Frontfacette des Laserchips und/oder das Koppelverhalten zwischen der Strahlung der einzelnen Laserkanäle je nach Einsatz des Lasers individuell optimiert werden kann.

Mit Blick auf die Erzeugung von Laserstrahlen besonders hoher Ausgangsleistung bei guter Strahlqualität wird es als vorteilhaft angesehen, wenn die Laserkanäle zumindest in Teilabschnitten des Laserchips optisch miteinander gekoppelt sind.

Als besonders vorteilhaft wird es angesehen, wenn durch die Krümmung des oder der Laserkanäle die Kopplung der Laserkanäle - im Vergleich zu ausschließlich geradlinigen Laserkanälen - verändert und die lateralen Fernfelder der an der Frontfacette austretenden Strahlmoden modifiziert sind.

Vorzugsweise ist durch die Krümmung des oder der Laserkanäle die Kopplung der Laserkanäle derart eingestellt, dass die Phasenlage der an der Frontfacette austretenden Strahlung der einzelnen Laserkanäle untereinander kleiner als 45°, vorzugsweise nahezu oder gleich Null, ist.

Gemäß einer besonders bevorzugten Ausgestaltung des Lasers ist vorgesehen, dass durch die Krümmung des oder der Laserkanäle und die Kopplung der Laserkanäle in dem oder den gekrümmten Abschnitten ein In-Phase-Mode mit - im Fernfeld - einer Hauptstrahlkeule und zwei neben der Hauptstrahlkeule divergent abstrahlenden Nebenkeulen gebildet wird.

Vorzugsweise weist der Laser einen externen Resonator auf, der einen Teil der von dem Laserchip an der Frontfacette austretenden Strahlung in den Laserchip zurückkoppelt.

Eine besonders vorteilhafte Ausgestaltung des Lasers sieht vor, dass der externe Resonator eine der Nebenkeulen oder beide Nebenkeulen des In-Phase-Modes ganz oder zum Teil zur Frontfacette des Laserchips reflektiert, die Hauptstrahlkeule den Resonator passiert und den Laser als Ausgangsstrahl verlässt und durch die Rückkopplung der Nebenkeule oder der Nebenkeulen die In-Phase-Mode im Laserchip anschwingt.

Vorzugsweise sind durch die Krümmung der Laserkanäle jeweils die Winkel der Laserkanäle an der Frontfacette und der Rückfacette unterschiedlich.

Mit Blick auf eine möglichst geringe Rückreflexion an der Frontfacette des Laserchips wird es als vorteilhaft angesehen, wenn der Winkel zumindest einiger der Laserkanäle, vorzugsweise aller Laserkanäle, zur Frontfacette ungleich 90° ist.

Vorteilhaft ist es, wenn der Winkel zumindest einiger der Laserkanäle, vorzugsweise aller Laserkanäle, zur Rückfacette gleich 90° ist und die Rückfacette mit einer reflektierenden Beschichtung versehen ist.

Die Form der aus dem Laserchip austretenden Moden lässt sich beispielsweise variieren, wenn die Laserkanäle voneinander abweichende Krümmungen aufweisen.

Alternativ kann vorgesehen sein, dass die Laserkanäle identische Krümmungen aufweisen und äquidistant verlaufen.

Auch kann vorgesehen sein, dass Teilbereiche der Laserkanäle gekrümmt und Teilbereiche der Laserkanäle geradlinig sind.

Wie bereits erwähnt, ist eine Kopplung der Laserkanäle je nach Anwendungsbereich vorteilhaft. Um eine Kopplung zu erreichen, werden die Laserkanäle bevorzugt ganz oder zumindest in Teilabschnitten des Laserchips optisch gekoppelt. Alternativ oder zusätzlich kann eine Kopplung der Strahlung außerhalb des Laserchips, beispielsweise durch einen externen Resonator erfolgen, der die Strahlung der Laserkanäle miteinander koppelt.

Die Erfindung wird nachfolgend anhand von Ausführungsbeispielen näher erläutert; dabei zeigen beispielhaft

Figur 1    ein erstes Ausführungsbeispiel für einen erfindungsgemäßen Laser mit einem Laserchip, wobei die Figur 1 den Laserchip in einem Querschnitt senkrecht zur Ausbreitungsrichtung der aktiven Laserkanäle des Laserchips zeigt,

Figur 2    den Laser gemäß Figur 1 in einer Sicht von oben,

Figur 3    ein anderes Ausführungsbeispiel für einen gekrümmten Verlauf der Laserkanäle bei dem Laser gemäß Figur 1,

Figur 4    ein weiteres Ausführungsbeispiel für einen gekrümmten Verlauf der Laserkanäle bei dem Laser gemäß Figur 1,

Figur 5    ein Ausführungsbeispiel für einen Laser, der mit einem Laserchip und einem externen Resonator ausgestattet ist,

Figur 6    beispielhaft den Verlauf der optischen Ausgangsleistung P über dem Strom I bei einem Laserchip mit geraden bzw. ungekrümmten Laserkanälen (gestrichelte Linie) und bei einem Laser mit gekrümmten Laserkanälen (durchgezogene Linie),

Figur 7    beispielhaft die stromabhängigen Spektren eines Laserchips mit gekrümmten Laserkanälen, wobei die Darstellung links in Figur 7 einen Laser ohne externen Resonator und die Darstellung rechts in Figur 7 einen Laser mit externem Resonator darstellt und wobei bei beiden Darstellungen jeweils die Leistung P über der Wellenlänge $\lambda$ in Nanometern und über dem Strom I in Ampere dargestellt ist,

Figur 8    beispielhaft die Entstehung des Fernfeldes eines Modes bei gekoppelten Laserkanälen, wobei die durchgezogene Linie in Figur 8 die Position einer durch den Abstand der Kanäle vorgegebenen möglichen Emissionskeule und die gestrichelte Linie in Figur 8 die durch die Emission der einzelnen Laserkanäle bestimmte Intensität der Emissionskeulen zeigt,

Figur 9    beispielhaft den Verlauf mehrerer Laserkanäle in einem Laserchip im Falle einer kurzen Krümmung der Laserkanäle in der Nähe der Frontfacette,

Figur 10    beispielhaft eine Modellierung des lateralen Fernfeldes eines oszillierenden Modes für zwei unterschiedliche Laserchips, wobei die Darstellung links in Figur 10 einen Laserchip mit geraden Laserkanälen und die Darstellung rechts in Figur 10 einen Laserchip mit gekrümmten Emittern zeigt und wobei jeweils die Intensität P über dem lateralen Fernfeldwinkel $\alpha$ dargestellt ist,

Figur 11    beispielhaft die Änderung der Phasenbeziehung zwischen benachbarten Laserkanälen durch unterschiedlich lange Wegstrecken aufgrund der Krümmung der Laserkanäle,

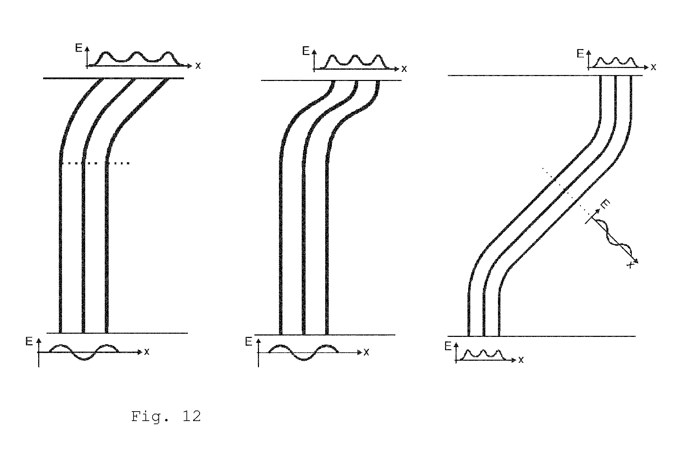

Figur 12    beispielhaft die Änderung der Phasenbeziehung zwischen benachbarten Laserkanälen derart, dass in der Auskoppelfacette bzw. Frontfacette eine Phasenbeziehung von 0° zwischen den benachbarten Laserkanälen vorliegt, während sie auf einer langen geraden Strecke im Inneren des Laserchips $\pi$ beträgt, wobei die Darstellung links in der Figur 12 die Emission unter einem zur Facettennormalen gekippten Winkel, die Darstellung in der Mitte in Figur 12 die Emission senkrecht zur Frontfacette durch Einführen einer S-Krümmung nahe der Frontfacette und die Darstellung rechts in Figur 12 die Emission senkrecht zur Frontfacette durch Einführung einer S-Krümmung mit mittig liegender gerader Strecke zeigt,

Figur 13    ein Ausführungsbeispiel für eine Form der Laserkanäle, bei der sich keine feste Phasenbeziehung zwischen den einzelnen Laserkanälen durch eine interne Kopplung ergibt,

Figur 14    ein Ausführungsbeispiel für einen V-Resonator, bei dem durch Variation von Position und Winkel eines teildurchlässigen Spiegels festgelegt werden kann, unter welchem Winkel emittiertes Licht in den Laserchip zurückgekoppelt wird und welcher Mode bevorzugt angeregt wird,

Figur 15    ein Ausführungsbeispiel für laterale Fernfelder eines Laserchips mit 419 gekrümmten Laserkanälen mit einem Abstand von jeweils 6 $\mu$m, wobei der jeweils anschwingende Mode durch einen externen Resonator vorgegeben wird, wobei in der linken Darstellung von Figur 15 ein oszillierender Mode und in der rechten Darstellung von Figur 15 der In-Phase-Mode dargestellt ist und wobei jeweils die Intensität P über dem lateralen Fernfeldwinkel $\alpha$ dargestellt ist,

Figur 16    beispielhaft laterale Fernfelder eines Laserchips mit 438 geraden Laserkanälen, bei dem ohne einen externen Resonator der oszillierende Mode anschwingt,

Figur 17    ein besonders bevorzugtes Ausführungsbeispiel für einen Laser, bei dem eine Anregung des In-Phase-Modes mit einem Fernfeld wie in Figur 15 rechts gezeigt erfolgt, indem die beiden äußeren Nebenkeulen des In-Phase-Modes zurückgekoppelt werden und die Hauptkeule des In-Phase-Modes ausgekoppelt wird und

Figur 18    ein Ausführungsbeispiel für die Ausgangsleistung-Strom-Kennlinie (P-I-Kennlinie) der Hauptemissionskeule eines 5 mm breiten Laserchips mit 419 gekrümmten Laserkanälen mit einem Abstand von je 6 μm (linke Darstellung in Figur 18) und die zugehörigen M²-Werte (rechte Darstellung in Figur 18).

In den Figuren werden der Übersicht halber für identische oder vergleichbare Komponenten stets dieselben Bezugszeichen verwendet.

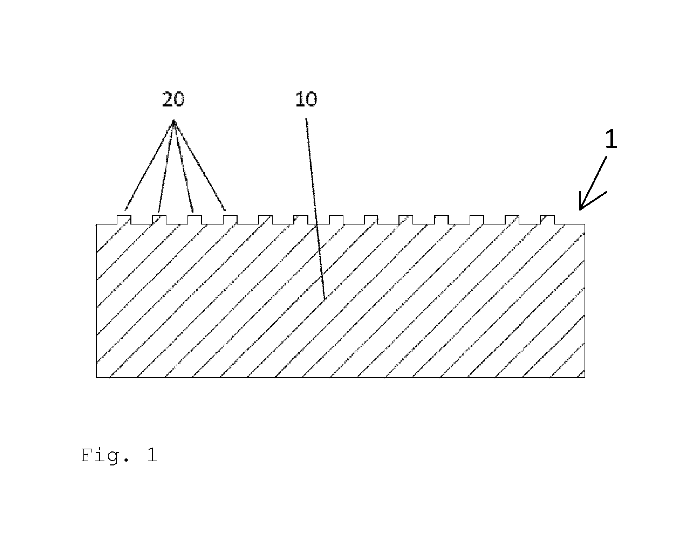

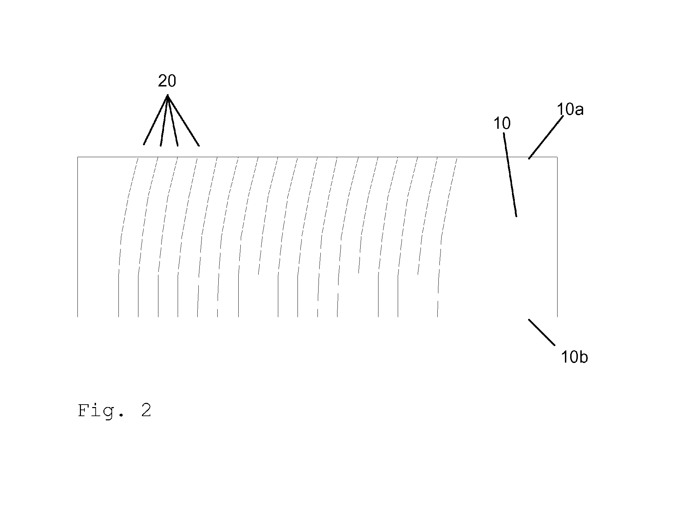

Die Figuren 1 und 2 zeigen einen Laser 1 mit einem Laserchip 10 in einem Schnitt entlang der Breite des Laserchips 10. Es ist eine Vielzahl an nebeneinander liegenden aktiven Laserkanälen 20 zu erkennen.

Der Laserchip 10 besteht vorzugsweise aus einem Halbleitermaterial, welches durch das Design der aktiven Bereiche eine effektive elektro-optische Umwandlung ermöglicht. Dieses ist z. B. mit einem Laserchip 10 aus GaAs möglich, dessen aktive Bereiche z. B. aus verschiedenen Schichten aus AlGaAs, InGaAs oder InAlGaAs gebildet werden. Die aktiven Laserkanäle 20 können durch Rippenwellenleiter gebildet werden, welche in die Chipoberfläche geätzt werden.

Die Rippen bzw. Rippenwellenleiter können Dimensionen im Bereich von einigen μm besitzen und der Abstand der Rippenwellenleiter zueinander kann wenige μm, aber auch deutlich mehr betragen. Die Figur 1 zeigt ein Beispiel, bei dem die einzelnen aktiven Laserkanäle 20 gleiche Abstände zueinander besitzen. Es ist aber auch möglich, dass zwischen den aktiven Laserkanälen 20 unterschiedliche Abstände realisiert sind oder auch Gruppen von aktiven Laserkanälen 20 existieren, die jeweils gleiche Abstände besitzen. Darüber hinaus können die aktiven Laserkanäle auch durch andere technische Strukturierungen der aktiven Halbleiterbereiche unter der Oberfläche des Laserchips erzeugt werden, wobei dann die Oberfläche des Laserchips weitgehend eben ist.

Die Figur 2 zeigt eine Aufsicht auf den Laserchip 10 gemäß Figur 1. Die vordere Kante bildet die Vorderfacette 10a des Laserchips 10, durch die die Strahlung austritt. Die hintere Kante bildet die Rückseiten-Facette bzw. Rückfacette 10b, welche im Allgemeinen hoch verspiegelt ist und aus der üblicherweise nur geringe oder keine Strahlung austritt. Man erkennt, dass die aktiven Laserkanäle 20 an der Rückseiten-Facette 10b jeweils einen rechten Winkel mit der Rückseiten-Facette 10b bilden. Dadurch wird eine optimale Reflexion der Strahlung und Rückkopplung in den jeweiligen aktiven Laserkanal erreicht.

An der Vorderfacette 10a besitzen die aktiven Laserkanäle 20 einen Winkel zu der Vorderfacette 10a, der von dem rechten Winkel abweicht. Durch diese Abweichung des Winkels kann die optische Rückkopplung der Strahlung in den jeweiligen aktiven Laserkanal durch die Reflexion an der Facette stark reduziert werden. Die Strahlung wird nach der Reflexion nicht mehr in den aktiven Laserkanal zurückgekoppelt, da sich der Winkel der reflektierten Strahlung deutlich von dem Winkel des jeweiligen aktiven Laserkanals unterscheidet. Die unterschiedlichen Winkel des aktiven Laserkanals an der Rückfacette 10b und der Vorderfacette 10a werden durch eine Krümmung der aktiven Laserkanäle 20 erreicht.

Die Figur 2 zeigt eine Ausgestaltung der aktiven Laserkanäle 20, bei der die parallel liegenden aktiven Laserkanäle alle eine kontinuierliche Krümmung über die gesamte Länge der Laserkanäle aufweisen.

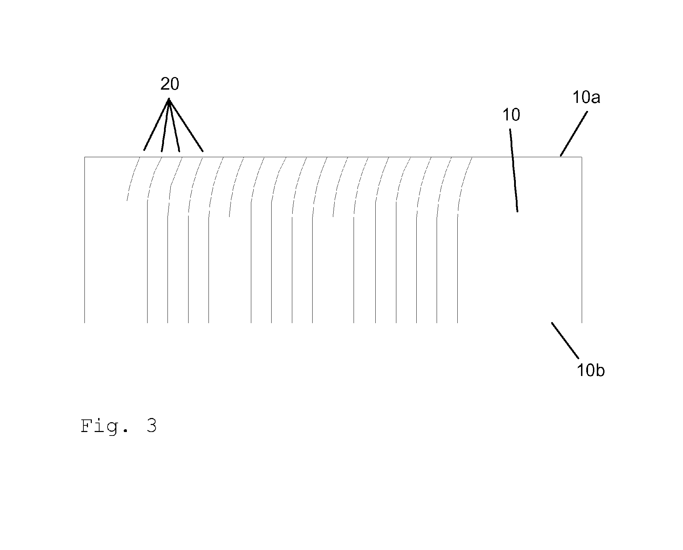

Figur 3 zeigt eine andere Ausgestaltung, bei der die aktiven Laserkanäle 20 von der Rückfacette 10b erst senkrecht und gerade verlaufen und dann erst in der Nähe der Vorderfacette 10a eine Krümmung aufweisen. Die aktiven Laserkanäle 20 besitzen also gerade als auch gekrümmte Kanalbereiche.

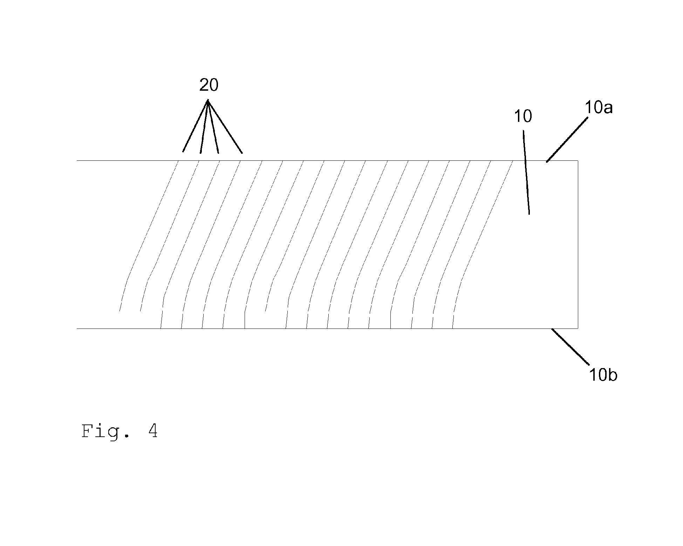

Die Figur 4 zeigt eine Ausgestaltung, bei der die aktiven Laserkanäle 20 senkrecht auf der Rückfacette 10b stehen und dort mit einer Krümmung beginnen. Danach verlaufen die aktiven Laserkanäle 20 aber in gerader Linie bis an die Vorderfacette, 10a, wo sie einen Winkel ungleich dem rechten Winkel zur Vorderfacette besitzen.

Die Ausgestaltungen gemäß den Figuren 2 bis 4 zeigen exemplarisch einige vorteilhafte Designs, bei denen die aktiven Laserkanäle 20 auf einem Laserchip 10 gleich gestaltet sind. Alternativ können die aktiven Laserkanäle 20 auf dem Laserchip 10 auch voneinander unterschiedliche Formen annehmen. Weiterhin müssen sie nicht gleiche Abstände besitzen und können in Gruppen angeordnet sein.

Durch enge Abstände der aktiven Laserkanäle 20 können die Strahlungsfelder der einzelnen aktiven Laserkanäle 20 auf dem Laserchip 10 in Wechselwirkung treten, und es können sich z. B. feste Phasenbeziehungen zwischen den Strahlungsfeldern der einzelnen aktiven Laserkanäle 20 auf dem Laserchip 10 herausbilden. Dadurch entstehen übergeordnete Strahlungsmoden, welche sowohl zu einer Reduzierung der Gesamtzahl der abgestrahlten Moden führen als auch zu einer Reduzierung des Raumbereiches (Winkelbereiches), in den abgestrahlt wird. Die Laserkanäle 20 können jedoch auch so weit auseinander liegen, dass die Kopplung der einzelnen Laserkanäle nur durch einen externen Resonator erreicht wird.

Weiterhin kann durch die Winkelstellung der aktiven Laserkanäle 20 an der Vorderfacette 10a die Rückreflexion sehr effektiv unterdrückt werden. Daher eignet sich diese Konfiguration besonders gut für eine Anordnung, bei der ein externer Resonator zur Bildung des Lasers 1 eingesetzt wird.

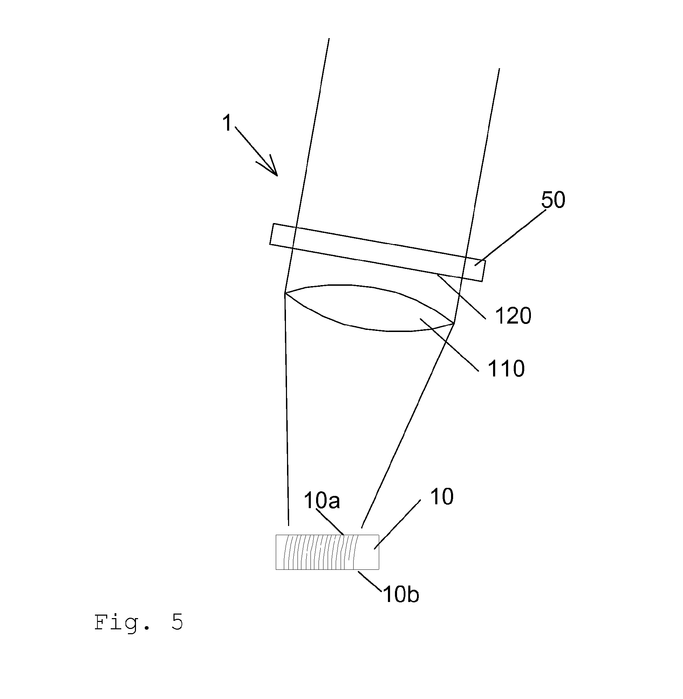

Die Figur 5 zeigt exemplarisch einen Laser 1 mit einem Laserchip 10 und einem externen Resonator 50. Die Strahlung, welche aus der Vorderfacette 10a des Laserchips 10 austritt wird, mit einer Linse 110 kollimiert. Ein Resonatorspiegel 120 eines externen Resonators 50 reflektiert den von der Linse 110 kollimierten Strahl, der durch die Linse 110 wieder in den Laserchip 10 zurückgekoppelt wird.

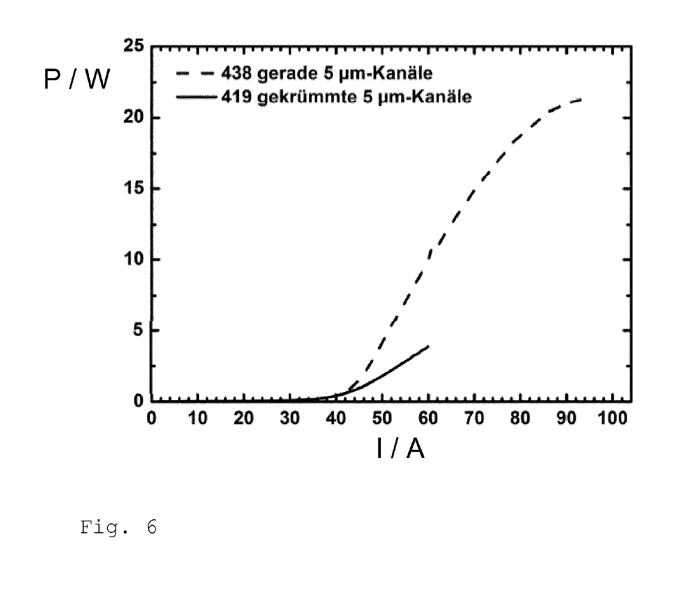

Durch das Einführen der Krümmung der Laserkanäle 20, wie sie oben im Zusammenhang mit den Figuren 2 bis 4 beispielhaft erläutert wurde, kann erreicht werden, dass die Laserkanäle 20 die Rückfacette 10b unter einem Winkel von 90° und die Frontfacette 10a unter einem Winkel ungleich 90° treffen. Somit kann die Reflektivität der Frontfacette 10a gezielt gesenkt werden unter Beibehaltung einer hohen Reflektivität der Rückfacette 10b. Dies soll beispielhaft anhand der Figur 6 erläutert werden:

Die Figur 6 zeigt gemessene Ausgangsleistung(P)-Strom(I)-Kennlinien zweier 5 mm breiter Laserchips 10 mit 438 geraden bzw. 419 gekrümmten Laserkanälen 20 mit antireflektierender Frontfacettenbeschichtung. Während der Laserchip 10 mit den geraden Laserkanälen 20 trotz antireflektierender Beschichtung ab einem Strom von etwa 42 A Lasertätigkeit aufweist (zu erkennen am linearen Anstieg der Leistung mit dem Strom), zeigt der Laserchip 10 mit gekrümmten Laserkanälen 20 nur einen schwachen Anstieg der Ausgangsleistung mit steigendem Strom, hier findet kein Lasing statt.

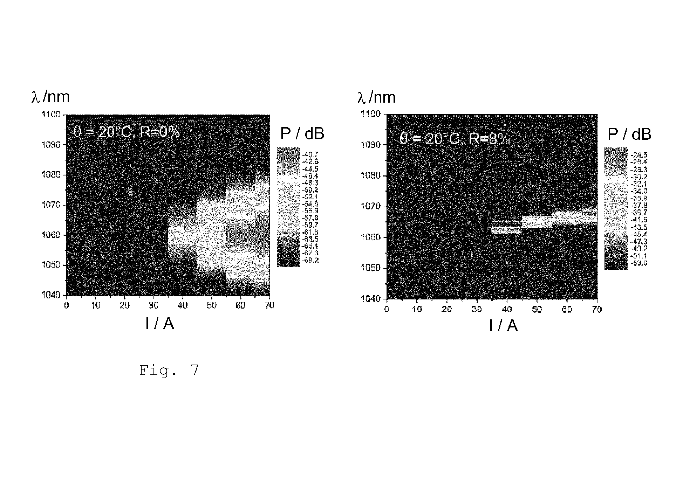

Die linke Seite von Figur 7 zeigt Spektren des Laserchips mit 419 gekrümmten Streifen als Funktion des Pumpstroms. Die große Breite des Spektrums sowie die geringe Leistung verdeutlichen, dass hier keine Lasertätigkeit stattfindet. Zum Vergleich sind auf der rechten Seite von Figur 7 stromabhängige Spektren desselben Laserchips mit externen Resonator abgebildet. Durch die Rückkopplung aufgrund des externen Resonators kommt es hier zum Lasing, wodurch sich die Breite des Spektrums deutlich verringert, wie es für Halbleiterlaser typisch ist.

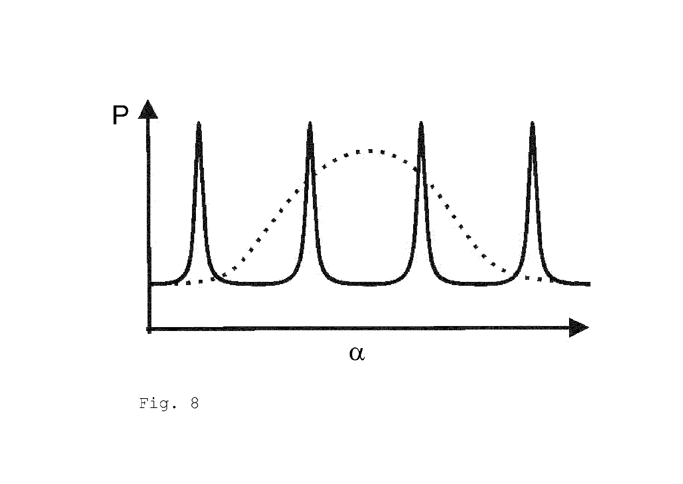

Durch die zur Facettennormalen gekippte Lichtemission (Winkel ungleich 90°) an der Vorderfacette ist es außerdem möglich, die Intensität zwischen den Emissionskeulen der auftretenden Supermoden umzuverteilen. Die Intensitätsverteilung eines Modes im Fernfeld wird bestimmt durch das Produkt der Emission aller Laserkanäle (die einzelnen Keulen des Supermodes, deren Position durch den Kanalabstand der Laserkanäle gegeben ist) und der Emission jedes einzelnen Laserkanals, wie sie ohne Kopplung gegeben wäre (siehe Figur 8).

Die Figur 8 zeigt die Entstehung des Fernfeldes eines Modes bei gekoppelten Laserkanälen. Die Positionen der möglichen Emissionskeulen sind durch den Abstand der Laserkanäle gegeben (durchgezogene Linie); die Intensität in diesen Keulen wird durch die Emission der einzelnen Laserkanäle bestimmt (gestrichelte Linie).

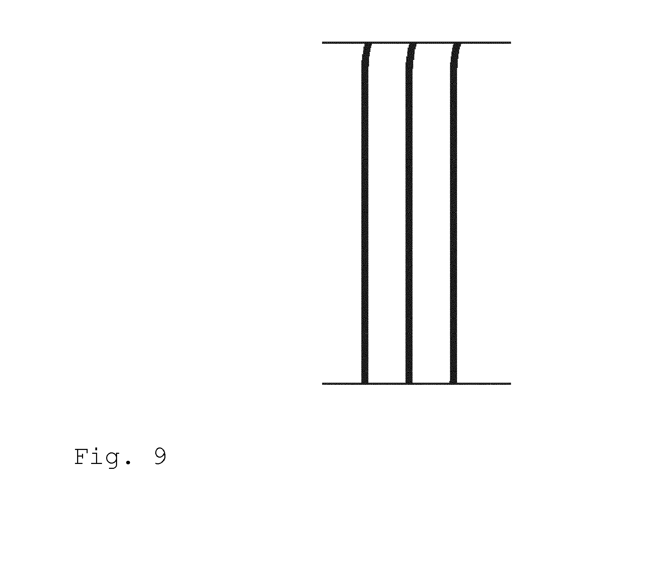

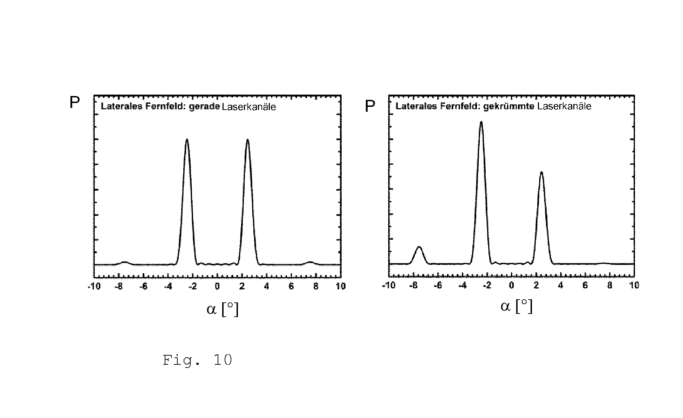

Durch eine Geometrie der Laserkanäle ähnlich der in Figur 9 gezeigten kann man nun den Winkel der Emission der einzelnen Laserkanäle variieren und damit die Intensität in den möglichen Emissionskeulen verändern. Die Figur 10 zeigt Modellierungsergebnisse für das laterale Fernfeld des oszillierenden Modes für zwei unterschiedliche Laserchips:

Links ist in der Figur 10 beispielhaft ein Laserchip mit geraden Laserkanälen gezeigt. Beide Hauptemissionskeulen sind gleich stark.

Rechts ist in der Figur 10 beispielhaft ein Laserchip mit nahe der Frontfacette gekrümmten Laserkanälen gezeigt; die Intensitätsverteilung zwischen den Keulen ist hier entsprechend dem Emissionswinkel der Laserkanäle seitlich verschoben. Beim Laserchip mit gekrümmten Laserkanälen zeigt sich also aufgrund der gekippten Emission eine Umverteilung der Intensität zwischen den Emissionskeulen. Diese kann durch geeignete Wahl der Krümmung so gewählt werden, dass z. B. die Verluste bei einer Kopplung mit einem externen Resonator minimiert werden können oder andere Resonatorgeometrien ermöglicht werden.

In Laserchips mit mehreren Laserkanälen, bei denen die einzelnen Laserkanäle nah genug nebeneinander liegen, tritt bereits innerhalb des Laserchips Kopplung auf. Bei gerade angeordneten Laserkanälen mit geringem Abstand zeigt sich dabei ein oszillierender Mode, bei dem jeweils benachbarte Laserkanäle einen Phasenunterschied von π aufweisen und eine Intensität von Null zwischen den einzelnen Laserkanälen auftritt. Da die Bereiche zwischen den einzelnen Laserkanälen nicht mit Strom gepumpt werden und in diesen somit Absorption auftritt, weist der oszillierende Mode demnach von allen Moden die geringsten Verluste innerhalb des Laserchips auf. Dieser Mode schwingt daher ohne externen Resonator bevorzugt an und lässt sich im externen Resonator am leichtesten fördern, was bei der gewollten Förderung eines anderen Modes hinderlich sein kann.

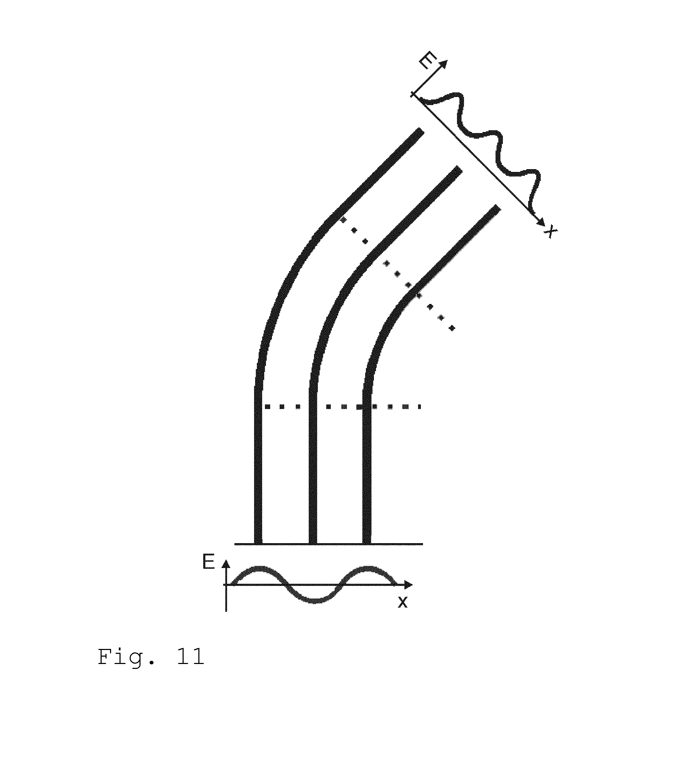

Durch Einführung einer Krümmung der Laserkanäle kann die Phasenbeziehung zwischen benachbarten Laserkanälen manipuliert werden. Aufgrund der Krümmung sind die Wegstrecken des Lichts in den einzelnen Laserkanälen unterschiedlich lang, wodurch sich die Phasenbeziehung zwischen den Laserkanälen mit dem Ort ändert. Die Figur 11 zeigt dies exemplarisch für drei Laserkanäle. Hier ist die Krümmung so gewählt, dass die Wegdifferenz benachbarter Laserkanäle $(2n+1)$-mal die Hälfte der Wellenlänge beträgt (n = 1, 2, 3, ...). Dies führt dazu, dass im unteren Teil eine Phasendifferenz von π vorliegt, im oberen Teil ist die Differenz 0.

Dieser Sachverhalt kann z. B. genutzt werden, um im Inneren eines Laserchips mit schon intern koppelnden Laserkanälen auf einer geraden langen Strecke eine Phasenbeziehung von π mit geringsten Verlusten zu erzielen und trotzdem an der Auskoppelfacette eine beliebige andere Phasenbeziehung zwischen benachbarten Laserkanälen zu erreichen und damit die Form des Fernfeldes zu manipulieren.

In der Figur 12 ist dieser Sachverhalt beispielhaft für einen Phasenunterschied von Null an der Auskoppelfacette dargestellt. Die Figur 12 zeigt die Änderung der Phasenbeziehung benachbarter Laserkanäle derart, dass an der Auskoppelfacette (oben) eine Phasenbeziehung von Null zwischen den benachbarten Laserkanälen vorliegt, während sie auf einer langen geraden Strecke im Chipinneren π beträgt. In der Figur 12 links ist die Emission unter einem zur Facettennormalen gekippten Winkel gezeigt. In der Mitte der Figur 12 ist die Emission senkrecht zur Vorderfacette durch Einführen eine S-Krümmung nahe der Vorderfacette gezeigt. Die Figur 12 zeigt rechts die Emission senkrecht zur Vorderfacette durch Einführen eine S-Krümmung mit mittig liegender gerader Strecke.

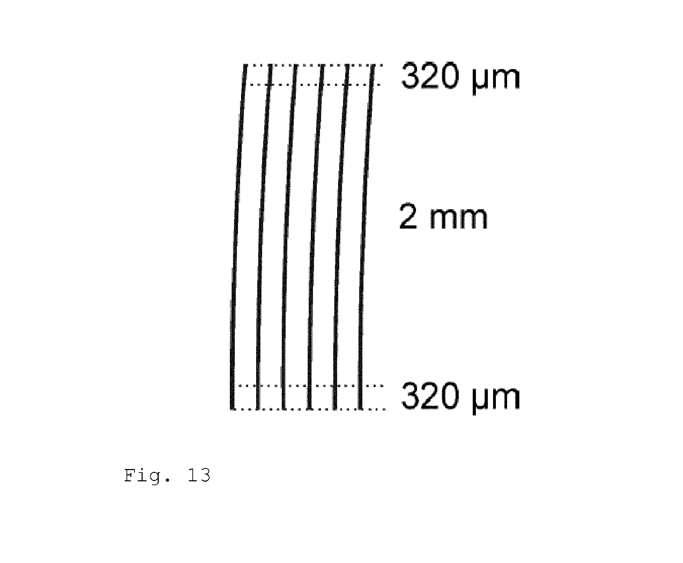

Neben der oben beschriebenen Ausnutzung der Krümmung zur Einstellung des Phasenunterschieds benachbarter Laserkanäle und der Intensitätsverteilung zwischen den unterschiedlichen Emissionskeulen ist es mittels Krümmungen auch möglich, die interne Kopplung und damit eine feste Phasenbeziehung zwischen benachbarten Laserkanälen gezielt zu verhindern. Dies resultiert darin, dass kein bestimmter Mode durch chipinterne Kopplung bevorzugt wird und die Auswahl des anschwingenden Modes nur durch den externen Resonator bestimmt werden kann. Dies kann z. B. durch eine Form der Laserkanäle (wie in Figur 13 gezeigt) erreicht werden. Hier ist der mittlere Teil der Laserkanäle über eine lange Strecke von 2 mm leicht gekrümmt, wodurch sich die Phasenbeziehung benachbarter Laserkanäle kontinuierlich verschiebt und sich somit keine durch interne Kopplung entstehende feste Phasenbeziehung zwischen den Laserkanälen ausbilden kann.

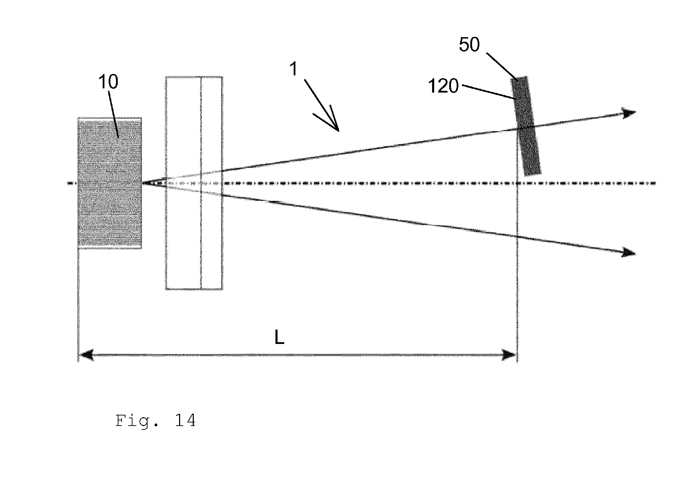

In erfinderseitig durchgeführten Experimenten an 5 mm breiten Laserchips 10 mit 419 gekrümmten Laserkanälen mit einem Abstand von je 6 μm zeigte sich, dass in einem V-Resonator 50 (vgl. Figur 14) sowohl der oszillierende Mode mit zwei Emissionskeulen als auch der In-Phase-Mode mit einer Haupt- und zwei Seitenkeulen problemlos angeregt werden können, je nach Spiegelstellung des Resonatorspiegels 120 des Resonators 50. Da durch interne Kopplung kein Mode bevorzugt wird, konnte die relative Phasenlage der einzelnen Laserkanäle von außen erfolgreich aufgeprägt werden. Die Länge L des Lasers 1 beträgt beispielsweise 800 mm.

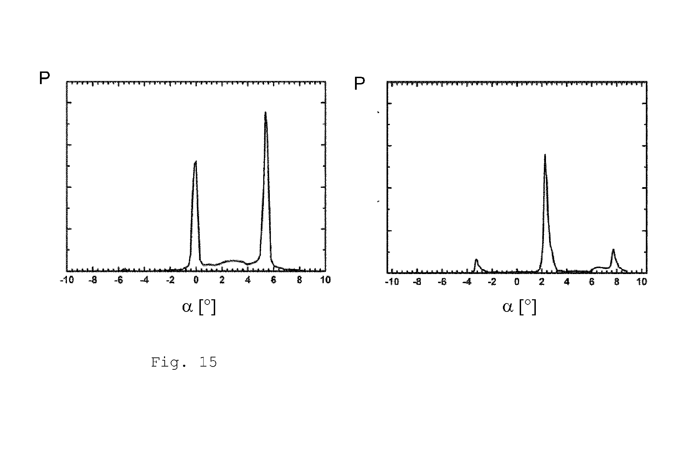

Die Figur 15 zeigt die gemessenen lateralen Fernfelder des Laserchips 10 im externen Resonator 50 bei der Anordnung gemäß Figur 14 für den beispielhaften Fall eines Laserchips mit 419 gekrümmten Laserkanälen mit einem Abstand von jeweils 6 μm. Der jeweils anschwingende Mode wurde durch den externen Resonator 50 vorgegeben. Die Darstellung links zeigt den oszillierenden Mode und die Darstellung rechts den In-Phase-Mode. Aufgrund der Krümmung der Laserkanäle sind die Fernfelder zusätzlich lateral verschoben.

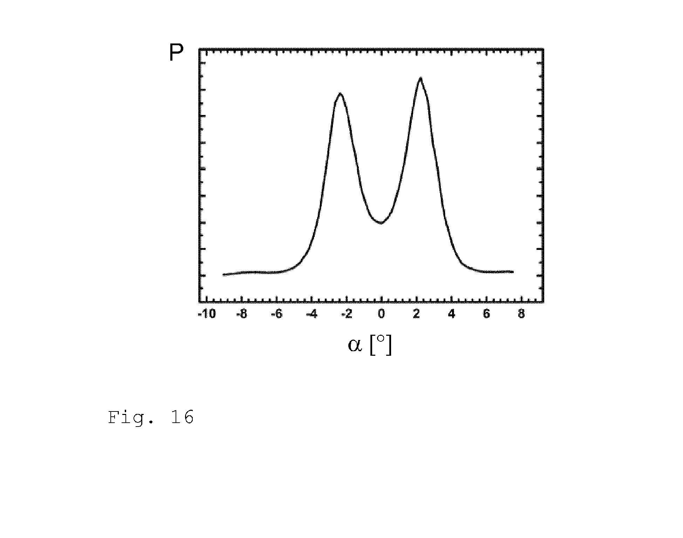

Vergleichende Messungen mit einem 5 mm breiten Laserchip mit 438 geraden Laserkanälen mit einem Abstand von jeweils 6 μm zeigen, dass ohne externen Resonator bevorzugt der oszillierende Mode anschwingt. Die Figur 16 zeigt beispielhaft das laterale Fernfeld des oszillierenden Modes im Betrieb ohne externen Resonator. Man sieht die lateralen Fernfelder eines Laserchips mit 438 geraden Laserkanälen.

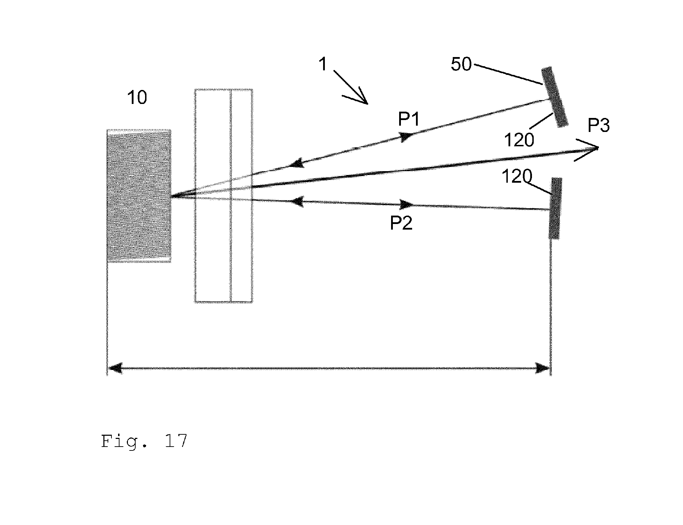

Die Möglichkeit, auch bei geringem Abstand der Laserkanäle im Laserchip andere Moden als den oszillierenden Mode stabil anregen zu können, eröffnet neue Möglichkeiten für das Design des externen Resonators. Beim oszillierenden Mode hat man immer mindestens zwei Emissionskeulen, die für Anwendungen außerhalb des Resonators wieder vereinigt werden müssen. Bei Anregung des In-Phase-Modes (wie in Figur 15 rechts gezeigt) kann man hingegen die beiden Nebenkeulen zur externen Kopplung nutzen, wodurch sich nur eine einzige Emissionskeule hinter dem Resonator bilden lässt. Ein solcher Aufbau ist exemplarisch in Figur 17 dargestellt.

Die Figur 17 zeigt ein weiteres Ausführungsbeispiel für einen Laser 1 mit einem Laserchip 10 und einem externen Resonator 50. Bei diesem Laser 1 erfolgt die Anregung des In-Phase-Modes mit einem Fernfeld, wie es in Figur 15 rechts gezeigt ist. Die beiden äußeren Nebenkeulen P1 und P2 werden mittels zweier symmetrisch um die Hauptstrahlkeule P3 angeordneter Resonatorspiegel 120 des Resonators 50 zurückgekoppelt, die Hauptstrahlkeule P3 wird ausgekoppelt.

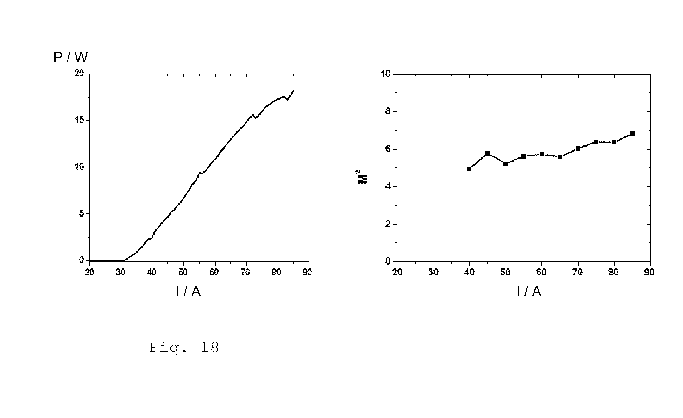

Bei dem Laser 1 gemäß Figur 17 konnte der In-Phase-Mode eines 5 mm breiten Laserchips mit 419 gekrümmten Laserkanälen mit einem Abstand von je 6 μm mittels des Resonators 50 angeregt und eine Ausgangsleistung der Hauptemissionskeule von 18 W erzielt werden (vgl. Figur 18 links). Die Strahlqualität war bis zu hohen Strömen von 85 A mit einem $M^2$-Wert von unter 7 exzellent (vgl. Figur 18 rechts).

Zum Vergleich: Der $M^2$-Wert eines 5 mm breiten Laserchips mit 438 geraden Laserkanälen mit einem Abstand von je 6 μm ohne externen Resonator zeigte einen hohen $M^2$-Wert von 45.

Die dimensionslose Beugungsmaßzahl $M^2$ ist ein Maß für die Strahlqualität eines (Laser-)strahls, die nach

$$M^2 = d_0 \ \Theta \ \pi \ / \ 4\lambda$$

vom Strahldurchmesser do, der Strahldivergenz $\Theta$ und der Wellenlänge $\lambda$ abhängt. Beugungsbegrenzte ideale Gaußstrahlen zeigen ein minimales $M^2$ von 1, während reale Laserstrahlen $M^2$-Werte größer 1 aufweisen. Je größer $M^2$ ist, umso schlechter ist der Strahl zu fokussieren, das heißt, umso größer ist der kleinste mögliche Fokusdurchmesser.

Bezugszeichenliste

1      Laser

10     Laserchip

| 10a | Vorderfacette / Frontfacette |
| 10b | Rückfacette |
| 20 | Laserkanal |
| 50 | Resonator |
| 110 | Linse |
| 120 | Resonatorspiegel |
| I | Strom |
| L | Länge |
| P | Ausgangsleistung / Intensität |
| P1 | Nebenkeule |
| P2 | Nebenkeule |
| P3 | Hauptstrahlkeule |
| α | Fernfeldwinkel |
| λ | Wellenlänge |

**Patentansprüche**

1. Laser (1) mit einem Laserchip (10), der eine Mehrzahl aktiver Laserkanäle (20), eine Frontfacette (10a) zur Auskopplung der Laserstrahlung der Laserkanäle (20) und eine Rückfacette (10b) zur rückseitigen Reflexion der Laserstrahlung der Laserkanäle (20) in Richtung Frontfacette (10a) aufweist, **dadurch gekennzeichnet, dass** zumindest einer der Laserkanäle (20) zumindest abschnittweise gekrümmt ist.

2. Laser (1) nach Anspruch 1, **dadurch gekennzeichnet, dass** die Laserkanäle (20) zumindest in Teilabschnitten des Laserchips (10) optisch miteinander gekoppelt sind.

3. Laser (1) nach einem der voranstehenden Ansprüche, **dadurch gekennzeichnet, dass** durch die Krümmung des oder der Laserkanäle(20) die Kopplung der Laserkanäle (20) - im Vergleich zu ausschließlich geradlinigen Laserkanälen (20) - verändert und die lateralen Fernfelder der an der Frontfacette (10a) austretenden Strahlmoden modifiziert sind.

4. Laser (1) nach einem der voranstehenden Ansprüche, **dadurch gekennzeichnet, dass**

durch die Krümmung des oder der Laserkanäle (20) die Kopplung der Laserkanäle (20) derart eingestellt ist, dass die Phasenlage der an der Frontfacette (10a) austretenden Strahlung der einzelnen Laserkanäle (20) untereinander kleiner als 45°, vorzugsweise nahezu oder gleich Null, ist.

5. Laser (1) nach einem der voranstehenden Ansprüche, **dadurch gekennzeichnet, dass** durch die Krümmung des oder der Laserkanäle (20) und die Kopplung der Laserkanäle (20) in dem oder den gekrümmten Abschnitten ein In-Phase-Mode mit - im Fernfeld - einer Hauptstrahlkeule (P3) und zwei neben der Hauptstrahlkeule (P3) divergent abstrahlenden Nebenkeulen (P1, P2) gebildet wird.

6. Laser (1) nach einem der voranstehenden Ansprüche, **dadurch gekennzeichnet, dass** der Laser (1) einen externen Resonator (50) aufweist, der einen Teil der von dem Laserchip (10) an der Frontfacette (10a) austretenden Strahlung in den Laserchip (10) zurückkoppelt.

7. Laser (1) nach Anspruch 6 in Kombination mit Anspruch 5, **dadurch gekennzeichnet, dass**

- der externe Resonator (50) eine der Nebenkeulen (P1, P2) oder beide Nebenkeulen (P1 + P2) des In-Phase-Modes ganz oder zum Teil zur Frontfacette (10a) des Laserchips (10) reflektiert,
- die Hauptstrahlkeule (P3) den Resonator (50) passiert und den Laser (1) als Ausgangsstrahl verlässt und
- durch die Rückkopplung der Nebenkeule (P1, P2) oder der Nebenkeulen (P1 + P2) der In-Phase-Mode im Laserchip (10) anschwingt.

8. Laser (1) nach einem der voranstehenden Ansprüche, **dadurch gekennzeichnet, dass** durch die Krümmung der Laserkanäle (20) jeweils die Winkel der Laserkanäle (20) an der Frontfacette (10a) und der Rückfacette (10b) unterschiedlich sind.

9. Laser (1) nach einem der voranstehenden Ansprüche, **dadurch gekennzeichnet, dass** der Winkel zumindest einiger der Laserkanäle (20) , vorzugsweise aller Laserkanäle (20), zur Frontfacette (10a) ungleich 90° ist.

10. Laser (1) nach einem der voranstehenden Ansprüche, **dadurch gekennzeichnet, dass**

- der Winkel zumindest einiger der Laserkanäle (20), vorzugsweise aller Laserkanäle (20), zur Rückfacette (10b) gleich 90° ist und

- die Rückfacette (10b) mit einer reflektierenden Beschichtung versehen ist.

11. Laser (1) nach einem der voranstehenden Ansprüche, **dadurch gekennzeichnet, dass** die Laserkanäle (20) voneinander abweichende Krümmungen aufweisen.

12. Laser (1) nach einem der voranstehenden Ansprüche, **dadurch gekennzeichnet, dass** die Laserkanäle (20) identische Krümmungen aufweisen und äquidistant verlaufen.

13. Laser (1) nach einem der voranstehenden Ansprüche, **dadurch gekennzeichnet, dass** Teilbereiche der Laserkanäle (20) gekrümmt und Teilbereiche der Laserkanäle (20) geradlinig sind.

14. Laser (1) nach einem der voranstehenden Ansprüche, **dadurch gekennzeichnet, dass** die Laserkanäle (20) ganz oder zumindest in Teilabschnitten des Laserchips (10) optisch entkoppelt sind.

15. Laser (1) nach einem der voranstehenden Ansprüche,
**dadurch gekennzeichnet, dass**
der externe Resonator (50) die Strahlung der Laserkanäle (20) miteinander koppelt.

20   10

1

Fig. 1

20

10a

10

10b

Fig. 2

Fig. 3

Fig. 4

Fig. 5

Fig. 6

Fig. 7

Fig. 8

Fig. 9

Fig. 10

Fig. 11

Fig. 12

320 µm

2 mm

320 µm

Fig. 13

Fig. 14

P

P

α [°]

α [°]

Fig. 15

Fig. 16

Fig. 17

P / W

I / A

I / A

Fig. 18

Europäisches
Patentamt

European
Patent Office

Office européen
des brevets

**EUROPÄISCHER RECHERCHENBERICHT**

Nummer der Anmeldung

EP 13 17 2422

| | EINSCHLÄGIGE DOKUMENTE | | |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (IPC) |
| X | WO 2008/140718 A1 (UNIV ILLINOIS [US]; COLEMAN JAMES J [US]; ELARDE VICTOR C [US]) 20. November 2008 (2008-11-20) * Abbildungen 2,4 * ----- | 1-3,11, 13 | INV. H01S5/10 H01S5/40 |
| X | ELARDE V C ET AL: "Curved Waveguide Array Diode Lasers for High-Brightness Applications", IEEE PHOTONICS TECHNOLOGY LETTERS, IEEE SERVICE CENTER, PISCATAWAY, NJ, US, Bd. 20, Nr. 13, 1. Juli 2008 (2008-07-01), Seiten 1085-1087, XP011215749, ISSN: 1041-1135 * Abbildung 2 * ----- | 1 | |
| X | JP H03 76188 A (SANYO ELECTRIC CO) 2. April 1991 (1991-04-02) * Abbildung 1 * ----- | 1 | |
| X | US 4 977 570 A (HASEGAWA MITSUTOSHI [JP]) 11. Dezember 1990 (1990-12-11) * Abbildungen 4,8 * ----- | 1 | RECHERCHIERTE SACHGEBIETE (IPC) H01S |

~~Der vorliegende Recherchenbericht wurde für alle Patentan~~sprüche erstellt

| Recherchenort | Abschlußdatum der Recherche | Prüfer |
|---|---|---|
| München | 19. November 2013 | Lendroit, Stéphane |

EPO FORM 1503 03.82 (P04C03)

Europäisches
Patentamt

European
Patent Office

Office européen
des brevets

**Nummer der Anmeldung**

EP 13 17 2422

## GEBÜHRENPFLICHTIGE PATENTANSPRÜCHE

Die vorliegende europäische Patentanmeldung enthielt bei ihrer Einreichung Patentansprüche, für die eine Zahlung fällig war.

☐ Nur ein Teil der Anspruchsgebühren wurde innerhalb der vorgeschriebenen Frist entrichtet. Der vorliegende europäische Recherchenbericht wurde für jene Patentansprüche erstellt, für die keine Zahlung fällig war, sowie für die Patentansprüche, für die Anspruchsgebühren entrichtet wurden, nämlich Patentansprüche:

☐ Keine der Anspruchsgebühren wurde innerhalb der vorgeschriebenen Frist entrichtet. Der vorliegende europäische Recherchenbericht wurde für die Patentansprüche erstellt, für die keine Zahlung fällig war.

## MANGELNDE EINHEITLICHKEIT DER ERFINDUNG

Nach Auffassung der Recherchenabteilung entspricht die vorliegende europäische Patentanmeldung nicht den Anforderungen an die Einheitlichkeit der Erfindung und enthält mehrere Erfindungen oder Gruppen von Erfindungen, nämlich:

Siehe Ergänzungsblatt B

☐ Alle weiteren Recherchengebühren wurden innerhalb der gesetzten Frist entrichtet. Der vorliegende europäische Recherchenbericht wurde für alle Patentansprüche erstellt.

☐ Da für alle recherchierbaren Ansprüche die Recherche ohne einen Arbeitsaufwand durchgeführt werden konnte, der eine zusätzliche Recherchengebühr gerechtfertigt hätte, hat die Recherchenabteilung nicht zur Zahlung einer solchen Gebühr aufgefordert.

☐ Nur ein Teil der weiteren Recherchengebühren wurde innerhalb der gesetzten Frist entrichtet. Der vorliegende europäische Recherchenbericht wurde für die Teile der Anmeldung erstellt, die sich auf Erfindungen beziehen, für die Recherchengebühren entrichtet worden sind, nämlich Patentansprüche:

☒ Keine der weiteren Recherchengebühren wurde innerhalb der gesetzten Frist entrichtet. Der vorliegende europäische Recherchenbericht wurde für die Teile der Anmeldung erstellt, die sich auf die zuerst in den Patentansprüchen erwähnte Erfindung beziehen, nämlich Patentansprüche:

1-3, 11, 13

☐ Der vorliegende ergänzende europäische Recherchenbericht wurde für die Teile der Anmeldung erstellt, die sich auf die zuerst in den Patentansprüchen erwähnte Erfindung beziehen (Regel 164 (1) EPÜ).

Europäisches
Patentamt

European
Patent Office

Office européen
des brevets

**MANGELNDE EINHEITLICHKEIT
DER ERFINDUNG
ERGÄNZUNGSBLATT B**

**Nummer der Anmeldung**

EP 13 17 2422

Nach Auffassung der Recherchenabteilung entspricht die vorliegende europäische Patentanmeldung nicht den Anforderungen an die Einheitlichkeit der Erfindung und enthält mehrere Erfindungen oder Gruppen von Erfindungen, nämlich:

1. Ansprüche: 1-3, 11, 13

Laser mit Laserkanälen, in dem zumindest einer der Laserkanäle zumindest abschnittweise gekrümmt ist.
Ein technischer Effekt kann wie folgt gesehen werden :
Modifizierung des lateralen Fernfeldes der austretenden Strahlung - im Vergleich zu ausschließlich geradlinigen Laserkanälen.

---

2. Ansprüche: 4-7, 15

Laser mit einer besonderen Phasenlage der austretenden Strahlung und/oder einem externen Resonator.
Die durch die technischen Merkmale dieser Ansprüche zu lösende Aufgabe kann wie folgt gesehen werden :
Besondere Einstellung der Phasenbeziehung zwischen Laserkanälen (z.B. vorzugsweise In-Phase-Mode) und/oder Rückkopplung einer Mehrzahl aktiver Laserkanäle.

---

3. Ansprüche: 8-10

Laser mit einer Mehrzahl aktiver Laserkanäle und besonderen Winkeln der Laserkanäle an der Frontfacette und der Rückfacette.
Die durch die technischen Merkmale dieser Ansprüche zu lösende Aufgabe kann wie folgt gesehen werden :
Erreichen einer maximalen Reflexion an der Rückfacette und geringen Rückreflexion an der Frontfacette

---

4. Anspruch: 12

Laser mit einer Mehrzahl aktiver Laserkanäle, in dem die Laserkanäle identische Krümmungen aufweisen und äquidistant verlaufen.
Die durch die technischen Merkmale dieser Ansprüche zu lösende Aufgabe kann wie folgt gesehen werden :
Besondere Umverteilung der Intensität in den unterschiedlichen Emissionskeulen der Strahlmoden der austretenden Strahlung.

---

5. Anspruch: 14

Laser mit einer Mehrzahl aktiver Laserkanäle, in dem die Laserkanäle ganz oder zumindest in Teilabschnitten des Laserchips optisch entkoppelt sind.
Die durch die technischen Merkmale dieser Ansprüche zu lösende Aufgabe kann wie folgt gesehen werden :

Europäisches
Patentamt

European
Patent Office

Office européen
des brevets

**Nummer der Anmeldung**

**MANGELNDE EINHEITLICHKEIT
DER ERFINDUNG
ERGÄNZUNGSBLATT B**

EP 13 17 2422

Nach Auffassung der Recherchenabteilung entspricht die vorliegende europäische Patentanmeldung nicht den Anforderungen an die Einheitlichkeit der Erfindung und enthält mehrere Erfindungen oder Gruppen von Erfindungen, nämlich:

Reduzierung der Chipinterne Modenkopplung zwischen den Laserkanälen.

---

**ANHANG ZUM EUROPÄISCHEN RECHERCHENBERICHT
ÜBER DIE EUROPÄISCHE PATENTANMELDUNG NR.**

EP 13 17 2422

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

19-11-2013

| Im Recherchenbericht angeführtes Patentdokument | Datum der Veröffentlichung | Mitglied(er) der Patentfamilie | Datum der Veröffentlichung |
|---|---|---|---|
| WO 2008140718 A1 | 20-11-2008 | US 2010195683 A1<br>WO 2008140718 A1 | 05-08-2010<br>20-11-2008 |
| JP H0376188 A | 02-04-1991 | JP 2798720 B2<br>JP H0376188 A | 17-09-1998<br>02-04-1991 |
| US 4977570 A | 11-12-1990 | JP H01184892 A<br>US 4977570 A | 24-07-1989<br>11-12-1990 |

EPO FORM P0461

Für nähere Einzelheiten zu diesem Anhang : siehe Amtsblatt des Europäischen Patentamts, Nr.12/82